# EUROPEAN PATENT APPLICATION

(11) **EP 3 651 189 A1**
(43) Date of publication of application: **13.05.2020**
(21) Application number: 18205160.7
(22) Date of filing: 08.11.2018
(51) Int. Cl.: H01L 21/8234

(54) **A METHOD FOR PRODUCING A GATE CUT STRUCTURE ON AN ARRAY OF SEMICONDUCTOR FINS**

(71) Applicant: IMEC vzw, 3001 Leuven (BE)
(72) Inventor: Chan, Mr. Boon Teik, 3001 Leuven (BE); Dentoni Litta, Mr. Eugenio, 3001 Leuven (BE); Ragnarsson, Mr. Lars-Ake, 3001 Leuven (BE); Oniki, Mr. Yusuke, 3001 Leuven (BE)
(74) Representative: Patent Department IMEC

(57) **Abstract**

The method of the invention is performed on a substrate (2) comprising on its surface an array of parallel semiconductor fins (1), and at least one dummy gate (4) oriented transversally to the fins, and flanked on each side by a spacer (5) and an interlayer dielectric (ILD) region (6). Replacement metal gate processing is applied to the substrate, wherein a gate dielectric (10) and a metal gate stack (11,12) replaces the dummy gates. In accordance with the invention, thinning of the metal gate stack stops short of fully removing the metal and is followed by etching back the metal gate to form a trench-shaped recess (13) between the spacers (5), with the gate dielectric (10) remaining on the side walls of the recess. A mask (14,15) is produced that defines an opening (17) across the recess (13), and self-aligned etching that is selective to the gate dielectric layer (10) is performed to produce a blind cavity (18) extending downward from the recess and situated between two adjacent fins (1) and between the spacers (5). The blind cavity is filled with a dielectric (19) to form simultaneously a gate cut structure (20) between two adjacent gates (21a,21b) and gate caps (22) on the adjacent gates as well as on other gates across the substrate (2).

## Description

### Field of the Invention

The present invention is related to semiconductor processing, in particular to finFET processing and the aspect of isolating neighbouring gate electrodes on a dense array of fin structures.

### State of the art.

The design rules for scaling fin-based semiconductor devices continue to evolve towards smaller dimensions. This evolution poses important challenges on the processing of these devices. One aspect that has demanded particular attention is the isolation of adjacent gate electrodes extending transversally across an array of semiconductor fins. The realization of so-called gate cut isolating structures has become more critical as the dimensions of the fins decreases.

Many process flows for fabricating nano-sized transistors in present day semiconductor processing apply the replacement metal gate (RMG) technique, wherein a sacrificial gate provided with lateral spacers is first produced tranversally on an array of parallel semiconductor fins. On silicon fins, the most commonly used material of the sacrificial gate, also called 'dummy gate', is polycrystalline silicon. This is followed by dopant implantation steps and possibly by the formation of epitaxial layers on the fin portions on either side of the dummy gate, for defining and shaping source and drain regions, and by the deposition of a dielectric layer (referred to as interlayer dielectric or ILD), to form ILD regions adjacent the spacers. The actual gate is formed by first removing the dummy gate, and depositing in its place a gate dielectric and a stack of metal layers across one or more fins.

The gate cut structures may be formed before or after the replacement metal gate process. The latter option allows to obtain a more dense arrangement of transistors on a given surface, but it also involves a number of technical difficulties. Cutting the gate post-RMG requires lithography and etching of the metal gate in a small area between two adjacent fins in one direction, and between two adjacent ILD regions in the direction perpendicular thereto. Overlay errors are difficult to control under such circumstances. Also, the unwanted etching of the ILD regions and gate spacers is a recurring problem in various existing solutions.

### Summary of the invention

The invention aims to provide a method that remedies the above-described deficiencies. This aim is achieved by the method according to the appended claims. The method of the invention is performed on a substrate comprising on its surface an array of parallel semiconductor fins, and at least one dummy gate oriented transversally to the fins, and flanked on each side by a spacer and an interlayer dielectric (ILD) region. Replacement metal gate processing is applied to the substrate, wherein a gate dielectric and a metal gate stack replaces the dummy gates. In accordance with the invention, thinning of the metal gate stack stops short of fully removing the metal and is followed by etching back the metal gate to form a trench-shaped recess between the spacers, with the gate dielectric remaining on the side walls of the recess. A mask is produced that defines an opening across the recess, and self-aligned etching that is selective to the gate dielectric layer is performed to produce a blind cavity extending downward from the recess, self-aligned to the recess in the direction perpendicular to said recess and situated between two adjacent fins and between the spacers. The blind cavity is filled with a dielectric to form simultaneously a gate cut structure between two adjacent gates and gate caps on the adjacent gates as well as on other gates across the substrate. The invention is in particular related to a method for producing a gate cut structure on an array of semiconductor fins, the method comprising the steps of :
- Providing a substrate comprising an array of mutually parallel semiconductor fins and transversely to said array, at least one dummy gate structure flanked on each side by a spacer and a dielectric region, wherein the upper surface of the spacers, the dummy gate structure and the dielectric regions is planar and essentially parallel to the plane of the substrate,
- Removing the dummy gate structure, thereby forming a gap between the spacers,
- providing first a gate dielectric layer and then a gate electrode layer conformally on the topography defined by the fins, the spacers and the dielectric regions, the conformal layers lining the sidewalls and bottom of the gap between the spacers, as well as the upper surface of the spacers and the dielectric regions,
- providing a non-conformal gate electrode layer that fills the gaps between all pairs of adjacent fins as well as the gap between the spacers, while forming a blanket layer on top of the dielectric regions and the spacers,
- Thinning the blanket layer, wherein the thinning is stopped prior to the exposure of the upper surface of the conformal gate electrode layer,
- Etching back the non-conformal and the conformal gate electrode layers until a trench-shaped recess is formed between the spacers, the bottom of the recess being higher than the fins, wherein the gate dielectric layer remains on the upper surface of the spacers and dielectric regions and on the side walls of the recess,
- Producing a mask that defines an opening above the recess, wherein the opening :
   ∘ is positioned in between two adjacent fins, as seen in the direction perpendicular to the fins,
   ∘ overlaps the recess in the direction perpendicular thereto, so that the opening exposes the recess itself and portions of the gate dielectric layer on either side of the recess,
- removing the non-conformal and the conformal gate electrode layers from an area defined by the opening, by an anisotropic etch process that is selective to the gate dielectric layer, so that the etch process is self-aligned in the direction perpendicular to the recess, to thereby form a blind cavity between two adjacent fins, the blind cavity extending downward from the recess, with the gate dielectric layer covering the sidewalls and the bottom of the blind cavity,
- removing the mask and removing the gate dielectric layer from the upper surface of the spacers and the dielectric regions, from the sidewalls of the recess and from the sidewalls and the bottom of the blind cavity,
- providing a non-conformal layer of a dielectric material that fills the blind cavity and the recess, and that forms a blanket layer on top of the dielectric regions and the spacers,
- thinning the non-conformal layer, thereby removing the blanket layer from the top of the dielectric regions and the spacers, so that the dielectric material in the blind cavity forms a gate cut structure, isolating a first and second gate one from the other, while the dielectric material in the recess forms a gate cap on top of the first and second gate.

According to an embodiment, the mask is a hardmask that is produced in direct contact with the gate dielectric layer. In the latter case, the hardmask may comprise at least a layer of spin-on-silicon (SoC) directly on the gate dielectric layer.

According to an embodiment, the method further comprises the step of forming an additional conformal layer, after the step of etching back the gate electrode layers, and before the step of producing the mask, wherein the mask is a hardmask produced in direct contact with the additional conformal layer, wherein subsequently the additional conformal layer is removed from the bottom of the opening defined by the mask, and wherein the additional conformal layer exhibits a higher selectivity to the anisotropic etch process used for producing the blind cavity than the material of the mask that is directly on the additional conformal layer. In the latter embodiment, the hardmask may comprise at least a layer of spin-on-silicon (SoC) directly on the gate dielectric layer and the additional conformal layer may be a layer of ruthenium.

In any of the above embodiments, the conformal gate dielectric layer may be a layer of HfO₂. The anisotropic etch process for forming the blind cavity may be a plasma etch using SF₆ and argon.

According to an embodiment, multiple mutually parallel dummy gates are arranged transversely with respect to the fins, each dummy gate being flanked by spacers, the assemblies of dummy gates and spacers being separated by dielectric regions, and wherein the full set of method steps according to any one of the preceding embodiments is applied on a first dummy gate or a first subgroup of dummy gates, while the method steps up to the formation of a recess are applied on all the dummy gates.

The invention is equally related to a semiconductor substrate comprising an array of mutually parallel semiconductor fins and transversely to said array, at least one gate structure comprising at least a first gate and a second gate, formed of a gate dielectric and a conductive gate electrode, wherein :
- the gate structure is flanked on each side by a spacer and a dielectric region,
- the upper surface of the spacers, and the dielectric regions is planar and essentially parallel to the plane of the substrate,
- the gate structure is recessed relative to the upper surface of the spacers and the dielectric regions, so that the upper surface of the gate structure forms the bottom of a trench-shaped recess relative to said upper surface,
- the recess is filled with a dielectric material, forming a gate cap on top of the gate structure,
- at least one dielectric gate cut structure extends downward from the gate cap, between two adjacent fins, thereby interrupting the gate dielectric and the gate electrode of the gate structure, so that the gate cut structure isolates the first gate from the second gate,
- the gate cut structure is aligned to the gate cap in the direction perpendicular to said gate cap.

In a substrate according to the invention, the gate dielectric layer may be a layer of HfO₂. The invention is equally related to a semiconductor component comprising a portion of a substrate according to the invention.

### Brief description of the figures

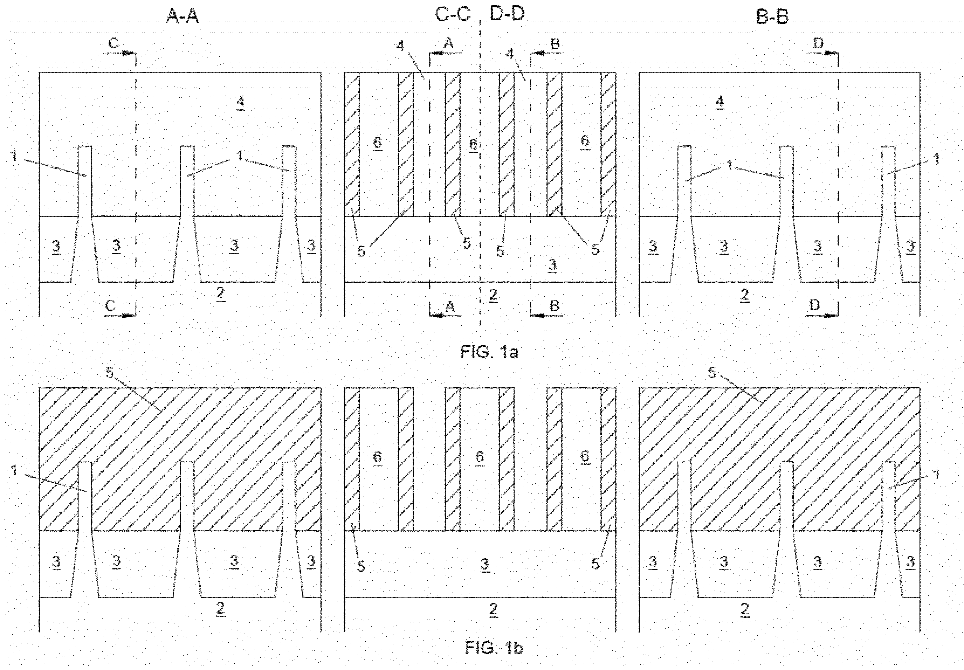

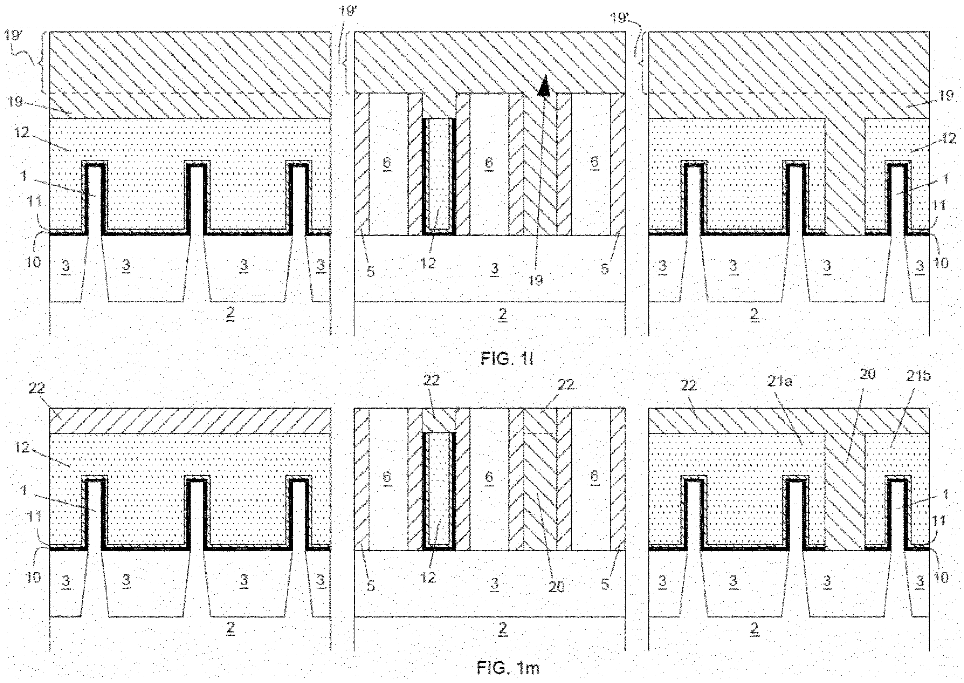

Figures 1a to 1m illustrate the method according to an embodiment of the invention. Each figure shows 3 images of a small portion of a horizontally arranged process wafer: the middle image is a combined view of two sections C-C and D-D by vertical planes parallel to the fins. The left and right images represent views of sections A-A and B-B along vertical planes perpendicular to the fins. The vertical section lines are indicated only in Figure 1a and are omitted in the other figures.

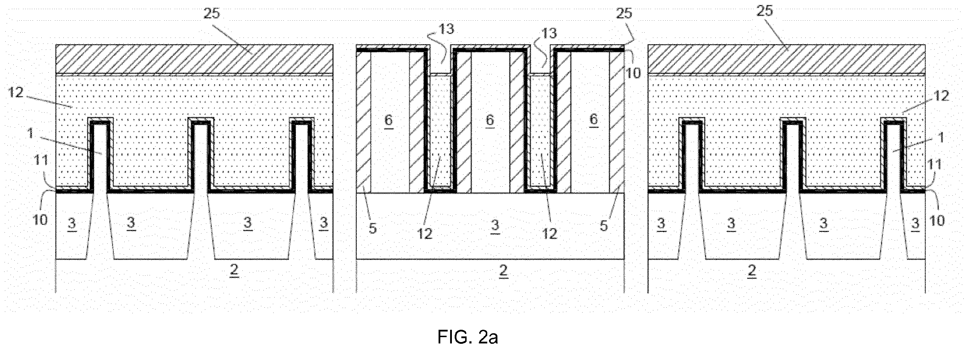

Figures 2a to 2e illustrate the key steps of a further embodiment, wherein an additional conformal layer is formed for improving the control of the critical dimension of the gate cut structure formed by the method.

### Detailed description of the invention

Figure 1a shows the starting point for the method according to an embodiment of the invention which will be described in detail hereafter. The materials identified are not intended as limitations of the scope of the invention but are given only by way of example. An array of mutually parallel silicon fins 1 is present on a substrate 2. The substrate 2 may for example be a bulk silicon wafer or a silicon-on-insulator (SOI) wafer, in which case the numeral 2 represents the silicon layer that forms the upper layer of the SOI wafer. The base areas of the fins 1 are separated by a dielectric material 3, known as a Shallow Trench Isolation (STI) dielectric, which may be silicon oxide. The STI dielectric 3 and the fins 1 are produced by lithography and etch techniques as known to the skilled person and therefore not described here in detail. The dimensions of the fins 1 may be in accordance with the most advanced technology nodes in terms of the size and density of fin-shaped features. This means that the distance between two fins may be between 20 and 50 nm, the width of the fins being in the order of 2 to 10 nm.

Oriented perpendicularly to the fins 1, an array of poly-silicon dummy gates 4 is provided. The dummy gates 4 are flanked by spacers 5 and separated by regions of interlayer dielectric 6. The production of the dummy gates 4, spacers 5 and ILD regions 6 may take place according to techniques and with the application of materials known in the art for this purpose. The drawings show a small portion of a process wafer, which normally comprises a high number of the above-described features on its surface. The upper surface of the dielectric regions 6, the dummy gates 4 and the spacers 5 is planar and essentially parallel to the plane of the process wafer 2.

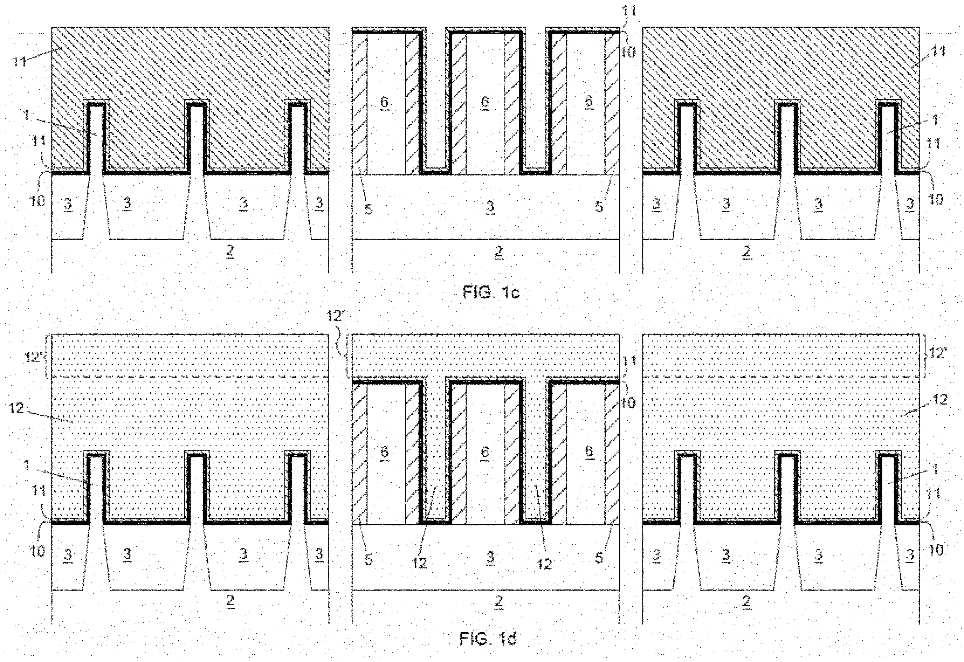

The replacement metal gate process is then started by applying the known steps of selectively removing the dummy gates 4, while maintaining the spacers 5 and the ILD regions 6, resulting in the situation shown in Figure 1b. Following this, and with reference to Figure 1c, a gate dielectric layer 10 and an electrically conductive layer 11 are consecutively deposited conformally on the topography defined by the ILD regions 6, the spacers 5 and the fins 1. The gate dielectric is preferably a high-K dielectric material. According to a preferred embodiment, the gate dielectric layer is a HfO₂ layer. The conductive layer 11 may comprise work function metals and/or other materials required for producing the gate electrode. Layer 11 may be a multilayer formed as a stack of several constituent layers. Layer 11 is hereafter and in the claims referred to as the 'conformal gate electrode layer'. Both layers 10 and 11 are 'conformal' in the sense that their thickness is such that the layers follow the topography defined by the spacers 5, the ILD regions 6 and the fins 1. In other words, after formation of the conformal layers 10 and 11, a gap remains between two adjacent spacers 5 and between two adjacent fins 1. As shown in Figure 1d, the gate electrode is completed by the deposition of a non-conformal electrically conductive layer 12, for example a layer of tungsten, that fills the gaps between the fins 1 and between the spacers 5, while forming a blanket layer 12' on top of the horizontal portions of the conformal layers 10 and 11. Layer 12 is 'non-conformal' in the sense that the layer fills the gaps defined by the above-named topography. The layer 12 may be deposited by chemical vapour deposition (CVD). If the gaps are very narrow, the deposition may be done in two steps: first atomic layer deposition (ALD) of tungsten, followed by CVD of tungsten.

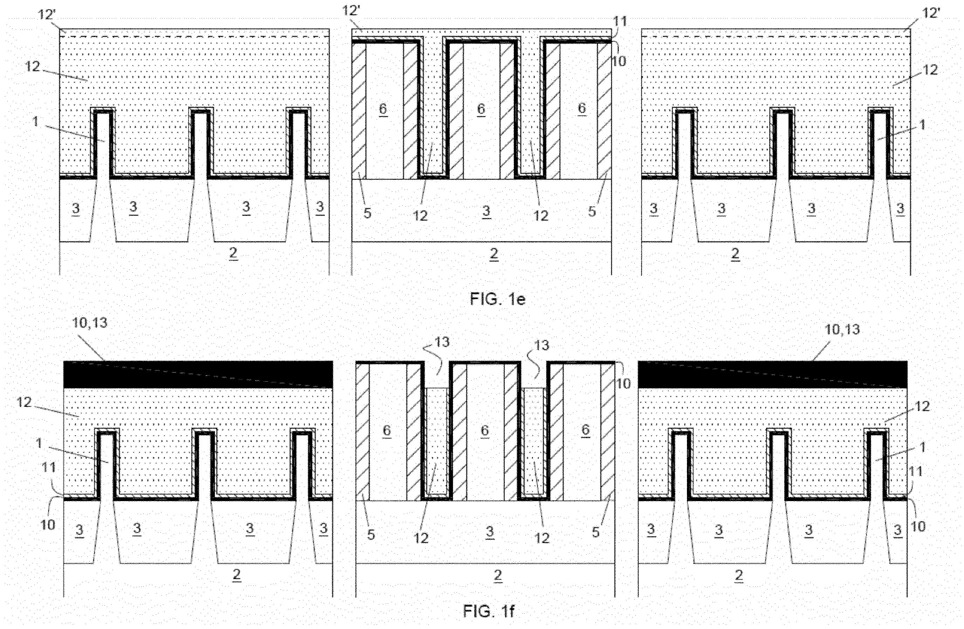

The blanket layer 12' is planarized and thinned by a suitable planarization technique, such as Chemical Mechanical Polishing (CMP), resulting in the situation shown Figure 1e. In accordance with the invention and as illustrated in Figure 1e, the CMP step does not remove the blanket layer 12' completely. The remaining thickness of the blanket layer 12' may be between 10 and 50 nm, more preferably between 20 and 30 nm. An etch process is then applied, (Fig. 1f) configured to remove the remaining thinned portion of the blanket layer 12' and the conformal gate electrode layer 11, while maintaining the conformal gate dielectric layer 10. A suitable etch process for this purpose when the gate dielectric is HfO₂, is a plasma etch using SF₆ as a precursor and argon as an inert gas. The etch continues until trench-shaped recesses 13 are formed between adjacent spacers 5. As shown in Figure 1f, the etch however stops short of reaching the top of the fins, i.e. the gate electrode 11+12 remains present on top of the fins 1.

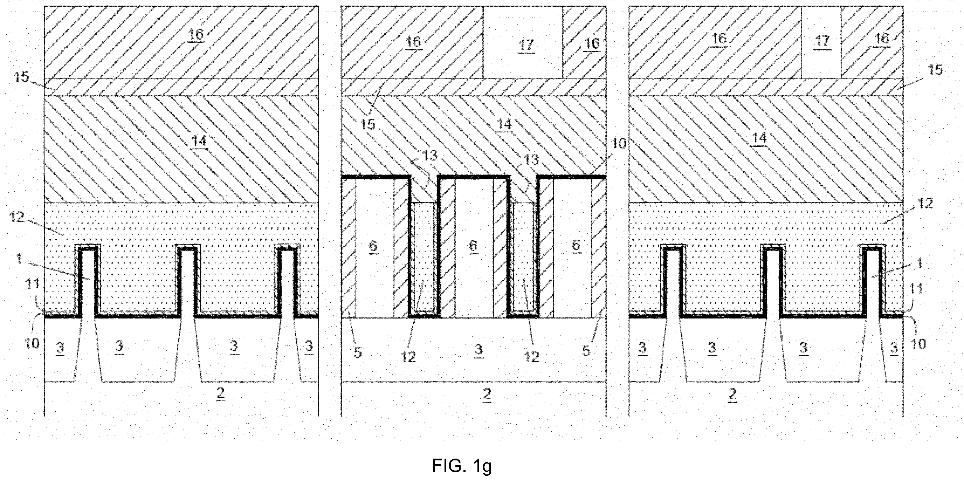

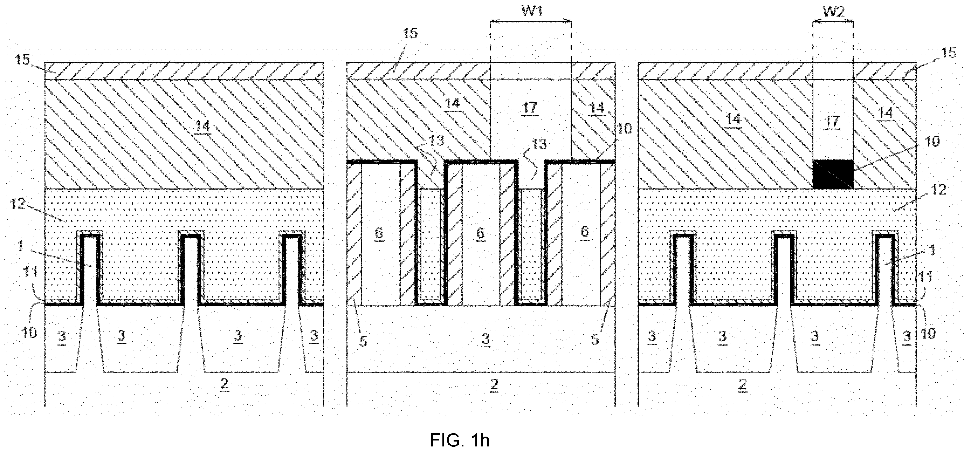

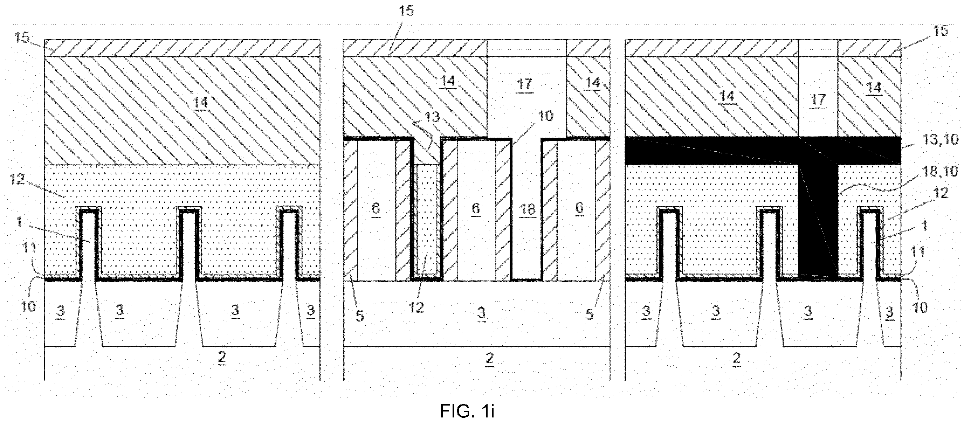

Then a hardmask is produced for performing the gate cut. According to a preferred embodiment illustrated in Figures 1g and 1h, a stack is formed of a SoC (spin-on carbon) layer 14 in direct contact with the gate dielectric layer 10, a SoG (spin-on glass) layer 15, and a photoresist layer 16. The photoresist layer 16 is patterned to form an opening 17 (Fig. 1g), after which the SoG 15 is etched so that the opening is transferred to this layer 15. Then the opening 17 is further transferred to the SoC layer 14, using the SoG layer 15 as a mask. Preferably the resist layer 16 is etched and thereby removed, simultaneously with the etching of the opening in the SoC layer 14 (see Fig. 1h). Possibly the SoG layer 15 is stripped at this point, but this layer may also remain, as is the case in the illustrated embodiment. The cross section of the opening 17 as seen in a horizontal plane is defined by its maximum dimensions W1 and W2, respectively in the direction of the fins and in the direction perpendicular thereto. The actual shape of the cross section of the opening depends on the characteristics of the lithography and etch processes used for creating the opening. The opening's cross section may be rectangular, square, circular or it may have straight and rounded portions. The first dimension W1 overlaps the width of the recess 13 formed above one of the recessed gates 11+12. W1 exceeds the width of the recess 13, i.e. the opening 17 fully exposes the recess 13 and horizontal portions of the gate dielectric 10 on either side thereof. In the direction of the fins, the opening 17 is situated between two adjacent fins 1. The dimension W2 is lower than the distance between the two adjacent fins, as shown in Figure 1h. With this mask in place, an anisotropic etch process is applied that removes the metal stack 11+12 from the area exposed by the opening 17 (see Figure 1i). The applied etch process is selective to the gate dielectric 10, i.e. the gate dielectric is not or only partially etched, so that in the direction of the fins 1, the etch process is self-aligned to the borders of the recess 13 (as defined by the conformal gate dielectric 10). The etch process may be a plasma etch using a chlorine or fluorine based etch chemistry, for example SF₆ and argon. The etch process cuts the gate electrode 11+12 in the area between two adjacent fins, defined by the dimension W2 of the mask opening 17, thereby forming a blind cavity 18 extending downward from the recess 13 between the two adjacent fins. The gate dielectric 10, possibly partially thinned, covers the side walls and the bottom of the blind cavity 18.

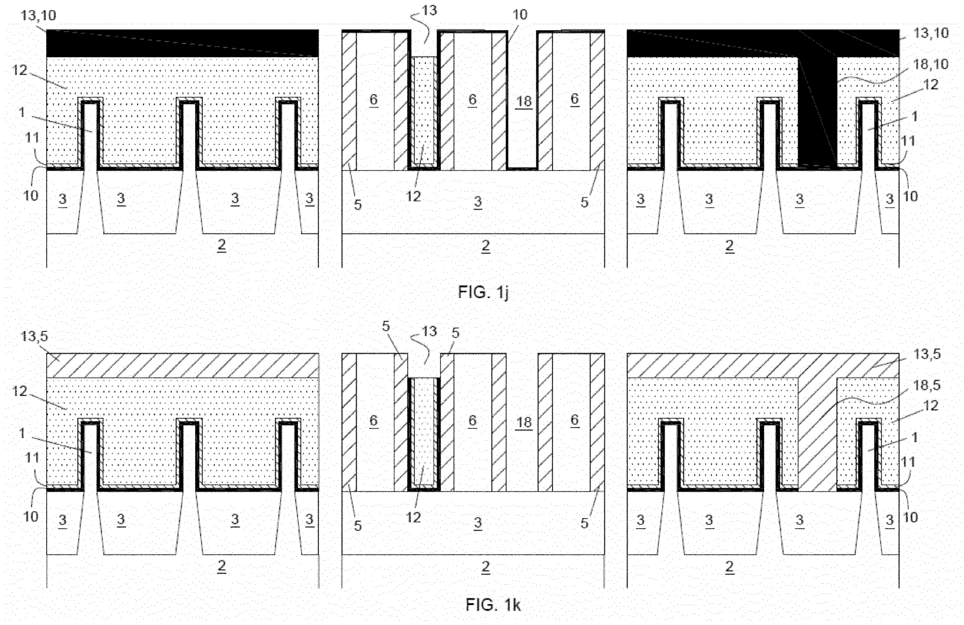

The SoC/SoG mask (14,15) is then stripped, see Figure 1j. The gate dielectric 10 is removed from the bottom and sides of the blind cavity 18 (Fig. 1k), and from the recesses 13 and the upper surface of the ILD regions 6 and spacers 5. If the gate dielectric is HfO₂, this may be realised by an etch process with a chlorine-based chemistry, for example a dry etch in an atmosphere comprising BCl₃/Cl₂ (10:1) and Ar at high temperature, for example 115 °C.

A dielectric material 19 is then produced (Fig. 1I), filling up the blind cavity 18 and the recesses 13, and forming a blanket layer 19' on the upper surface of the ILD regions 6 and the spacers 5. The dielectric 19 may for example be silicon nitride (Si₃N₄). According to an embodiment suitable when the cavity 18 and recesses 13 are too small to be filled with Si₃N₄, a liner of Si₃N₄ may first be applied on the inner surface of the cavity 18 and the recesses 13 by Atomic Layer Deposition (ALD), followed by deposition of an oxide, for example SiO₂, by Flowable Chemical Vapour Deposition (FCVD). The blanket layer 19' is then thinned and planarized, preferably by CMP (Fig. 1m), stopping on the upper surface of the ILD regions 6 and the spacers 5. As a result, a gate cut structure 20 is formed which isolates two opposing ends of two gate electrodes 21a and 21b from each other. Simultaneously with the formation of the gate cut structure, gate caps 22 (also known as gate plugs) are formed on top of the gate electrodes 21a and 21 b, as well as on the other gate electrodes formed on the process wafer.

The above-described method has several advantages over the prior art. First, there is the fact that the CMP for thinning the blanket portion 12' of the gate electrode layer 12 stops short of fully removing the blanket layer 12'. This enables the further removal of the remainder of layer 12' and the creation of recesses 13 in such a way that the gate dielectric 10 remains, so as to protect the spacers 5 and ILD regions 6 during the self-aligned etching of the gate electrode material to form the blind cavity 18. The fact that the gate electrodes are recessed across the process wafer enables the simultaneous formation of gate cut structures and gate caps, thereby reducing the number of process steps required for isolating the gate electrodes.

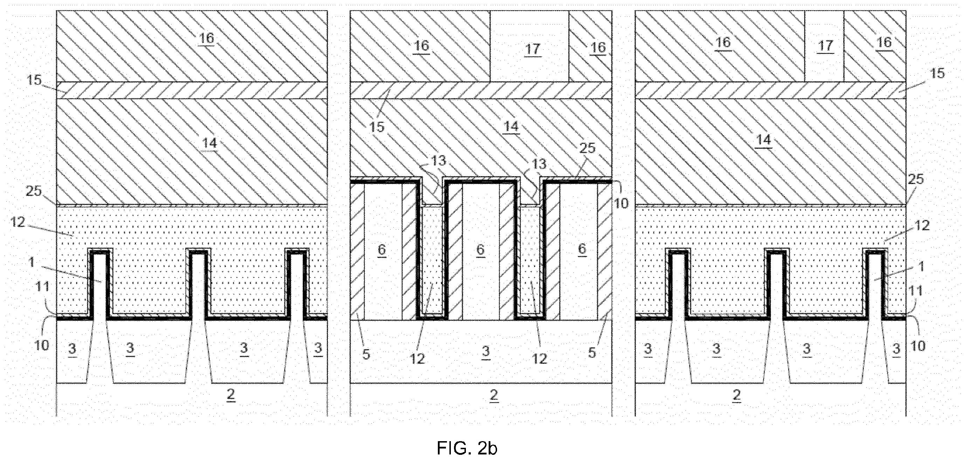

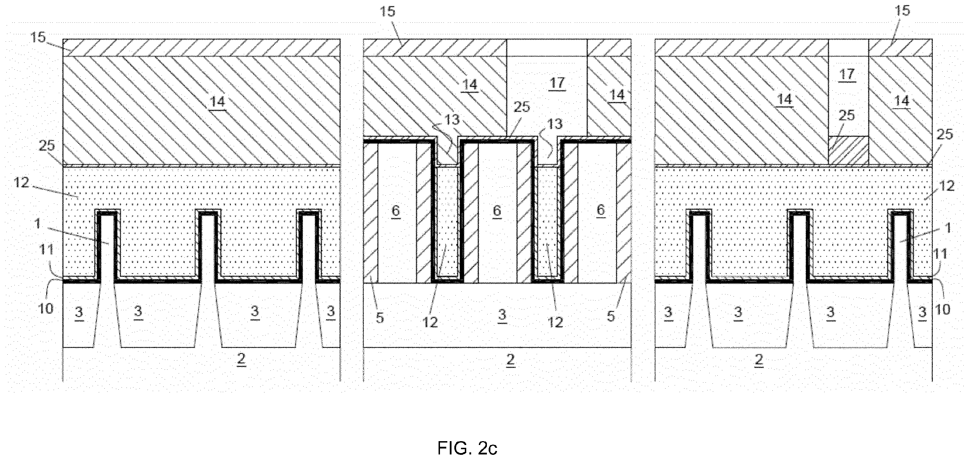

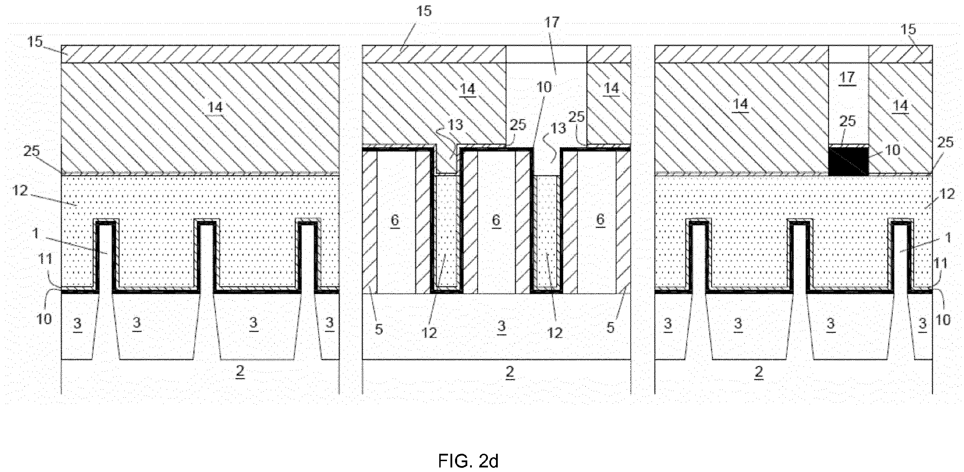

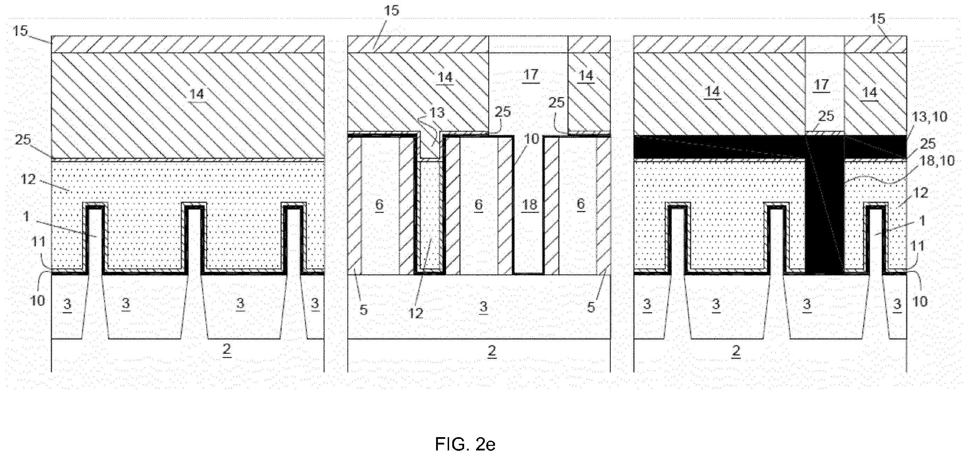

One further embodiment is illustrated in Figures 2a to 2e. According to this embodiment, and as illustrated in Figure 2a, an additional conformal layer 25 is produced on top of the conformal gate electrode layer 11, after the formation of the recesses 13, and prior to the formation of the mask 14+15+16 (Fig. 2b). When the mask comprises a SoC layer 14 directly on the conformal layer 25, the conformal layer 25 may be a ruthenium layer, as the ruthenium exhibits higher selectivity to the anisotropic etch process for producing the blind cavity 18 than the SoC layer 14, when the anisotropic etch process uses a fluorine or chlorine based etch chemistry (e.g. SF₆ and argon). After etching through the SoC and SoG layers to form the opening 17 (Figure 2c), the additional layer 25 is removed from the bottom of the opening 17 (see Figure 2d) by a suitable etch process, which may be an oxide and chlorine-based etch process when the layer is a Ru layer, for example a dry etch in an atmosphere of O₂/Cl₂ (10:1) at 60°C. Because Ru exhibits higher selectivity than SoC, the Ru layer 25 forms an additional protection of the edges of the blind cavity 18, as seen in the section perpendicular to the fins, thereby strengthening these edges and ensuring that the critical dimension of the blind cavity 18 and thereby of the gate cut structure 20 is controlled during the totality of the self-aligned anisotropic etch process applied for producing the blind cavity 18 (see Figure 2e). In general, the additional conformal layer 25 may be any layer that exhibits higher selectivity to the anisotropic etch process for forming the blind cavity 18, than the mask material directly on the additional layer 25.

The method of the invention may be applied on a single dummy gate as described above, or simultaneously on a plurality of dummy gates on a process wafer, by providing a suitable mask defining a plurality of openings 17. As stated above, the step of forming the recesses 13 is performed on every gate that is being produced in the replacement gate process, i.e. not only on the gates which are cut. The method is therefore capable of forming one or more gate cut structures simultaneously with a plurality of gate caps on a process wafer.

The invention is equally related to a substrate provided with an array of fins 1 and a gate structure comprising the two gates 21a and 21b separated by a gate cut structure 20 obtained by the method of the invention. The gate structure is oriented along a single line transversally to the fins. The gate structure comprises a gate cap 22 oriented along the gate direction, with the gate cut structure 20 extending downward from the gate cap and being aligned thereto in the direction perpendicular to said gate cap. The invention is related to the substrate as such, and to any semiconductor component such as an integrated circuit chip, produced from a portion of the substrate.

While the invention has been illustrated and described in detail in the drawings and foregoing description, such illustration and description are to be considered illustrative or exemplary and not restrictive. Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

Unless specifically specified, the description of a layer being present, deposited or produced 'on' another layer or substrate, includes the options of
- said layer being present, produced or deposited directly on, i.e. in physical contact with, said other layer or substrate, and
- said layer being present, produced or deposited on one or a stack of intermediate layers between said layer and said other layer or substrate.

## Claims

1. A method for producing a gate cut structure (20) on an array of semiconductor fins (1), the method comprising the steps of :
• Providing a substrate (2) comprising an array of mutually parallel semiconductor fins (1) and transversely to said array, at least one dummy gate structure (4) flanked on each side by a spacer (5) and a dielectric region (6), wherein the upper surface of the spacers (5), the dummy gate structure (4) and the dielectric regions (6) is planar and essentially parallel to the plane of the substrate (2),
• Removing the dummy gate structure (4), thereby forming a gap between the spacers (5),
• providing first a gate dielectric layer (10) and then a gate electrode layer (11) conformally on the topography defined by the fins (1), the spacers (5) and the dielectric regions (6), the conformal layers (10,11) lining the sidewalls and bottom of the gap between the spacers (5), as well as the upper surface of the spacers (5) and the dielectric regions (6),
• providing a non-conformal gate electrode layer (12) that fills the gaps between all pairs of adjacent fins (1) as well as the gap between the spacers (5), while forming a blanket layer (12') on top of the dielectric regions (6) and the spacers (5),
• Thinning the blanket layer (12'), wherein the thinning is stopped prior to the exposure of the upper surface of the conformal gate electrode layer (11),
• Etching back the non-conformal and the conformal gate electrode layers (12,11) until a trench-shaped recess (13) is formed between the spacers (5), the bottom of the recess being higher than the fins (1), wherein the gate dielectric layer (10) remains on the upper surface of the spacers (5) and dielectric regions (6) and on the side walls of the recess (13),
• Producing a mask (14,15) that defines an opening (17) above the recess (13), wherein the opening :
∘ is positioned in between two adjacent fins (1), as seen in the direction perpendicular to the fins,
∘ overlaps the recess (13) in the direction perpendicular thereto, so that the opening (17) exposes the recess itself and portions of the gate dielectric layer (10) on either side of the recess,
• removing the non-conformal and the conformal gate electrode layers (12,11) from an area defined by the opening (17), by an anisotropic etch process that is selective to the gate dielectric layer (10), so that the etch process is self-aligned in the direction perpendicular to the recess (13), to thereby form a blind cavity (18) between two adjacent fins (1), the blind cavity extending downward from the recess (13), with the gate dielectric layer (10) covering the sidewalls and the bottom of the blind cavity (18),
• removing the mask (14,15) and removing the gate dielectric layer (10) from the upper surface of the spacers (5) and the dielectric regions (6), from the sidewalls of the recess (13) and from the sidewalls and the bottom of the blind cavity (18),
• providing a non-conformal layer (19) of a dielectric material that fills the blind cavity (18) and the recess (13), and that forms a blanket layer (19') on top of the dielectric regions (6) and the spacers (5),
• thinning the non-conformal layer (19), thereby removing the blanket layer (19') from the top of the dielectric regions (6) and the spacers (5), so that the dielectric material in the blind cavity (18) forms a gate cut structure (20), isolating a first and second gate (21a,21b) one from the other, while the dielectric material in the recess (13) forms a gate cap (22) on top of the first and second gate (21a,21b).

2. The method according to claim 1, wherein the mask is a hardmask (14,15) that is produced in direct contact with the gate dielectric layer (10).

3. The method according to claim 2, wherein the hardmask comprises at least a layer of spin-on-silicon (SoC) directly on the gate dielectric layer (10).

4. The method according to claim 1, further comprising the step of forming an additional conformal layer (25), after the step of etching back the gate electrode layers (11,12), and before the step of producing the mask (14,15), wherein the mask is a hardmask produced in direct contact with the additional conformal layer (25), wherein subsequently the additional conformal layer (25) is removed from the bottom of the opening (17) defined by the mask, and wherein the additional conformal layer (25) exhibits a higher selectivity to the anisotropic etch process used for producing the blind cavity (18) than the material of the mask that is directly on the additional conformal layer (25).

5. The method according to claim 4, wherein the hardmask comprises at least a layer of spin-on-silicon (SoC) directly on the gate dielectric layer (10) and wherein the additional conformal layer (25) is a layer of ruthenium.

6. The method according to any one of the preceding claims, wherein the conformal gate dielectric layer (10) is a layer of HfO₂.

7. The method according to any one of the preceding claims, wherein the anisotropic etch process for forming the blind cavity (18) is a plasma etch using SF₆ and argon.

8. The method according to any one of the preceding claims, wherein multiple mutually parallel dummy gates (4) are arranged transversely with respect to the fins (1), each dummy gate being flanked by spacers (5), the assemblies of dummy gates and spacers being separated by dielectric regions (6), and wherein the full set of method steps according to any one of the preceding claims is applied on a first dummy gate or a first subgroup of dummy gates, while the method steps up to the formation of a recess (13) are applied on all the dummy gates.

9. A semiconductor substrate comprising an array of mutually parallel semiconductor fins (1) and transversely to said array, at least one gate structure comprising at least a first gate (21a) and a second gate (21b), formed of a gate dielectric (10) and a conductive gate electrode (11,12), wherein
- the gate structure is flanked on each side by a spacer (5) and a dielectric region (6),
- the upper surface of the spacers (5), and the dielectric regions (6) is planar and essentially parallel to the plane of the substrate (2),
- the gate structure is recessed relative to the upper surface of the spacers (5) and the dielectric regions (6), so that the upper surface of the gate structure forms the bottom of a trench-shaped recess (13) relative to said upper surface,
- the recess is filled with a dielectric material, forming a gate cap (22) on top of the gate structure,
- at least one dielectric gate cut structure (20) extends downward from the gate cap (22), between two adjacent fins (1), thereby interrupting the gate dielectric (10) and the gate electrode (11,12) of the gate structure, so that the gate cut structure (20) isolates the first gate (21a) from the second gate (21b),
- the gate cut structure (20) is aligned to the gate cap (22) in the direction perpendicular to said gate cap (22).

10. The substrate according to claim 9, wherein the gate dielectric layer is a layer of HfO₂.

11. A semiconductor component comprising a portion of a substrate according to claim 9 or 10.
